# EUROPEAN PATENT APPLICATION

(11) **EP 4 332 718 A1**
(43) Date of publication of application: **06.03.2024**
(21) Application number: 22823899.4
(22) Date of filing: 21.04.2022
(51) Int. Cl.: G05F 1/56

(54) **SIGNAL DEVICE, AND METHOD FOR ADJUSTING COLLECTOR VOLTAGE OF TRAVELING-WAVE TUBE OF SIGNAL DEVICE**

(30) Priority: 16.06.2021 CN 202110666378
(71) Applicant: Huawei Technologies Co., Ltd., Shenzhen, Guangdong 518129 (CN)
(72) Inventor: CHENG, Qianfu, Shenzhen, Guangdong 518129 (CN); WANG, Guangjian, Shenzhen, Guangdong 518129 (CN); CAI, Hua, Shenzhen, Guangdong 518129 (CN)
(74) Representative: Pfenning, Meinig & Partner mbB
(86) International application number: PCT/CN2022/088206
(87) International publication number: WO 2022/262413

(57) **Abstract**

A signal apparatus (10) of a traveling-wave tube (100) and a method for adjusting a collector voltage of the traveling-wave tube (100) thereof are provided. The method is applied to the signal apparatus (10) including the traveling-wave tube (100), and includes: when a voltage is provided for a collector (170) of the traveling-wave tube (100) by using a first collector voltage value, and working data of the collector (170) does not meet a preset working condition, adjusting the first collector voltage value corresponding to a first reference signal input to the traveling-wave tube (100) to a second collector voltage value, so that the working data of the collector (170) meets the preset working condition when a voltage is provided for the collector (170) by using the second collector voltage value. According to the method, a collector voltage may be adjusted within a preset value range of the collector voltage based on a collector voltage corresponding to a reference signal currently input to the traveling-wave tube (100), so that a collector power of the traveling-wave tube (100) meets a preset working condition, thereby dynamically adjusting the collector voltage of the traveling-wave tube (100) and further reducing power consumption of the traveling-wave tube (100).

## Description

This application claims priority to Chinese Patent Application No. 202110666378.5, filed with the China National Intellectual Property Administration on June 16, 2021 and entitled "SIGNAL APPARATUS AND METHOD FOR ADJUSTING COLLECTOR VOLTAGE OF TRAVELING-WAVE TUBE THEREOF", which is incorporated herein by reference in its entirety.

### TECHNICAL FIELD

This application relates to wireless communication technologies, and in particular, to a signal apparatus of a traveling-wave tube and a method for adjusting a collector voltage of a traveling-wave tube thereof.

### BACKGROUND

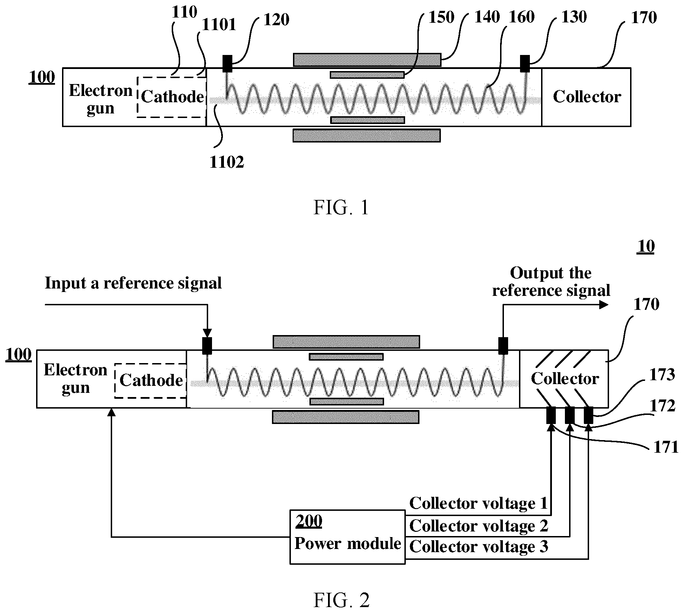

In a wireless communication system, a traveling-wave tube is a common device for amplifying a reference signal. A structure of a traveling-wave tube 100 is shown in FIG. 1. The traveling-wave tube 100 includes an electron gun 110, an input energy transmission window 120, an output energy transmission window 130, a magnetic focusing system 140, a concentrated attenuator 150, a slow-wave circuit 160, and a collector 170. The electron gun 110 further includes a cathode 1101 that can emit electrons. The electron gun 110 is configured to emit an electron beam 1102 to the collector 170, and the collector 170 receives the electron beam 1102. The magnetic focusing system 140 and the concentrated attenuator 150 are configured to maintain a shape of the electron beam 1102 to ensure that the electron beam 1102 smoothly passes through the slow-wave circuit 160. A reference signal enters the slow-wave circuit 160 through the input energy transmission window 120, and travels along the slow-wave circuit 160. Electrons of the electron beam 1102 exchange energy with a traveling microwave field, so that the reference signal is amplified. An amplified reference signal is output through the output energy transmission window 130.

In an existing signal apparatus 10 including the traveling-wave tube 100 in FIG. 1, as shown in FIG. 2, the signal apparatus 10 includes the traveling-wave tube 100 and a power module 200. The power module 200 is configured to supply power to the electron gun 110 of the traveling-wave tube 100. In addition, the power module 200 further provides a collector voltage for the collector 170 of the traveling-wave tube 100, and is configured to reclaim electrons of the electron beam 1102 from the collector 170. As shown in FIG. 2, the power module 200 provides a collector voltage 1 to a collector voltage 3 with different values for an input end 171 to an input end 173 of the collector 170 of the traveling-wave tube 100, so that a voltage of the electron beam 1102 reaching the collector 170 is greater than a voltage of the collector 170, thereby collecting electrons having different energy distributions. However, in an actual system, the reference signal input to the traveling-wave tube 100 changes in real time. If the collector voltage cannot adaptively changes with the reference signal, power consumption of the traveling-wave tube 100 is relatively high, and efficiency is low.

### SUMMARY

This application is intended to provide a method for adjusting a collector voltage of a traveling-wave tube, applied to a signal apparatus including a traveling-wave tube.

A first aspect of this application provides a method for adjusting a collector voltage of a traveling-wave tube, applied to a signal apparatus including a traveling-wave tube. The method includes:
obtaining a first collector voltage value corresponding to a first reference signal;
determining whether working data of a collector of the traveling-wave tube meets a preset working condition when a voltage is provided for the collector by using the first collector voltage value; and
when the preset working condition is not met, adjusting the first collector voltage value corresponding to the first reference signal in a preset mapping relationship to a second collector voltage value, where the working data of the collector meets the preset working condition when a voltage is provided for the collector by using the second collector voltage value.

In a possible implementation of the first aspect, the preset working condition is a preset working data threshold of the collector.

To be specific, in this embodiment of this application, the signal apparatus may store a mapping table, and the mapping table may store a correspondence between at least one group of first reference signals and first collector voltage values. The mapping table may be dynamically searched for a corresponding first collector voltage value based on a first reference signal input to the traveling-wave tube, so that power is supplied to the collector of the traveling-wave tube.

In a possible implementation of the first aspect, the working data includes a working current or a power of the collector, and the preset working data threshold includes a preset current threshold or a preset power threshold.

To be specific, in this embodiment of this application, when the working data of the traveling-wave tube is a power, the preset working data threshold may be a preset total power threshold of the collector of the traveling-wave tube. That the preset working condition is not met means that a power of the traveling-wave tube is greater than the preset total power threshold after the first collector voltage value is applied to the collector of the traveling-wave tube. In other words, when the power of the traveling-wave tube is greater than the preset total power threshold, a loss of extra power consumption is generated for the traveling-wave tube.

In a possible implementation of the first aspect, the adjusting the first collector voltage value corresponding to the first reference signal in a preset mapping relationship to a second collector voltage value includes:
determining an adjustment range of the first collector voltage value based on a preset value; and
selecting, from the adjustment range, a voltage value that meets the preset working condition as the second collector voltage value.

To be specific, in this embodiment of this application, the preset value may be an adjustment range threshold of the first collector voltage value. The adjustment range is determined by using a sum and a difference of a value determined by multiplying the first collector voltage value by the adjustment range threshold and the first collector voltage value. When the working data of the traveling-wave tube is a power, the second collector voltage value determined from the adjustment range enables the power of the traveling-wave tube to be less than the preset total power threshold.

In a possible implementation of the first aspect, the selecting, from the adjustment range, a voltage value that meets the preset working condition as the second collector voltage value includes:
when a plurality of voltage values within the adjustment range meet the preset working condition, selecting a voltage value with minimum power consumption of the collector as the second collector voltage value.

To be specific, in this embodiment of this application, power consumption of the collector may be a collector power. When a plurality of second collector voltage values within the adjustment range enable the collector power of the traveling-wave tube to be less than the preset total power threshold, the second collector voltage value that minimizes the collector power of the traveling-wave tube is selected, so that power consumption of the traveling-wave tube can be reduced.

In a possible implementation of the first aspect, the first reference signal includes any one of a reference signal input to the traveling-wave tube, a reference signal output by the traveling-wave tube, and a power back-off signal of the traveling-wave tube.

In a possible implementation of the first aspect, when the signal apparatus meets a preset detection condition, and a voltage is provided for the collector by using the first collector voltage value, it is determined whether the working data of the collector meets the preset working condition. The preset detection condition includes that the signal apparatus detects that current time reaches a preset time range or current load of the signal apparatus is less than a preset load threshold.

To be specific, in this embodiment of this application, for example, the preset load threshold may be 40%. When workload of the signal apparatus is less than 40%, it is determined whether the working data of the collector meets the preset working condition. The preset time range may be from midnight to six o'clock of the next day. In this way, impact on normal working of the signal apparatus can be avoided.

A second aspect of this application provides a signal apparatus, including a traveling-wave tube and a power adjustment module.

The power adjustment module is configured to:
obtain a first collector voltage value corresponding to a first reference signal;
determine whether working data of a collector of the traveling-wave tube meets a preset working condition when a voltage is provided for the collector by using the first collector voltage value; and
when the preset working condition is not met, adjust the first collector voltage value corresponding to the first reference signal in a preset mapping relationship to a second collector voltage value, where the working data of the collector meets the preset working condition when a voltage is provided for the collector by using the second collector voltage value.

In a possible implementation of the second aspect, the preset working condition is a preset working data threshold of the collector.

To be specific, in this embodiment of this application, the power adjustment module may include a power control module and a detection module. The power control module may store a mapping table, and the mapping table may store a correspondence between at least one group of first reference signals and first collector voltage values. The power control module may dynamically search the mapping table for a corresponding first collector voltage value based on a first reference signal input to the traveling-wave tube, so that power is supplied to the collector of the traveling-wave tube.

In a possible implementation of the second aspect, the working data includes a working current or a power of the collector, and the preset working data threshold includes a preset current threshold or a preset power threshold.

To be specific, in this embodiment of this application, when the working data of the traveling-wave tube is a power, the preset working data threshold may be a preset total power threshold of the collector of the traveling-wave tube. That the preset working condition is not met means that a power of the traveling-wave tube is greater than the preset total power threshold after the power control module applies the first collector voltage value to the collector of the traveling-wave tube. In other words, when the power of the traveling-wave tube is greater than the preset total power threshold, a loss of extra power consumption is generated for the traveling-wave tube.

In a possible implementation of the second aspect, that the power adjustment module adjusts the first collector voltage value corresponding to the first reference signal in a preset mapping relationship to a second collector voltage value includes:
the power adjustment module determines an adjustment range of the first collector voltage value based on a preset value; and
the power adjustment module selects, from the adjustment range, a voltage value that meets the preset working condition as the second collector voltage value.

To be specific, in this embodiment of this application, the preset value may be an adjustment range threshold of the first collector voltage value. The power adjustment module may determine the adjustment range by using a sum and a difference of a value determined by multiplying the first collector voltage value by the adjustment range threshold and the first collector voltage value. When the working data of the traveling-wave tube is a power, the second collector voltage value determined from the adjustment range enables the power of the traveling-wave tube to be less than the preset total power threshold.

According to the adjustment method in the first aspect of this application, the mapping table may be searched for a corresponding collector voltage based on a reference signal currently input to the traveling-wave tube, to supply power to the collector of the traveling-wave tube. The collector voltage is adjusted within a preset value range of the collector voltage, so that a collector power that is of the traveling-wave tube and that corresponds to the collector voltage meets the preset working condition, and a correspondence between a reference signal and a collector voltage in the mapping table is updated, thereby dynamically adjusting the collector voltage of the traveling-wave tube and further reducing power consumption of the traveling-wave tube.

In a possible implementation of the second aspect, that the power adjustment module selects, from the adjustment range, a voltage value that meets the preset working condition as the second collector voltage value includes:
when a plurality of voltage values within the adjustment range meet the preset working condition, the power adjustment module selects a voltage value with minimum power consumption of the collector as the second collector voltage value.

To be specific, in this embodiment of this application, power consumption of the collector may be a collector power. When a plurality of second collector voltage values within the adjustment range enable the collector power of the traveling-wave tube to be less than the preset total power threshold, the power adjustment module selects the second collector voltage value that minimizes the total collector power of the traveling-wave tube, so that power consumption of the traveling-wave tube can be reduced.

In a possible implementation of the second aspect, the first reference signal includes any one of a reference signal input to the traveling-wave tube, a reference signal output by the traveling-wave tube, and a power back-off signal of the traveling-wave tube.

In a possible implementation of the second aspect, the signal apparatus further includes a detector or a coupler, and the detector or the coupler is disposed at an input end of the traveling-wave tube.

In a possible implementation of the second aspect, the detector or the coupler is disposed at an output end of the traveling-wave tube.

To be specific, in this embodiment of this application, when the first reference signal is a reference signal input to the traveling-wave tube, the detector or the coupler is disposed at the input end of the traveling-wave tube; or when the first reference signal is a reference signal output by the traveling-wave tube, the detector or the coupler is disposed at the output end of the traveling-wave tube.

In a possible implementation of the second aspect, the signal apparatus further includes a detector, the detector is disposed at an input end of the traveling-wave tube, is communicatively connected to the power adjustment module, and is configured to obtain a power value of the first reference signal input to the input end of the traveling-wave tube, and send the power value to the power adjustment module. The detector may alternatively be disposed at an output end of the traveling-wave tube, and be communicatively connected to the power adjustment module, and be configured to obtain a power value of the first reference signal at the output end of the traveling-wave tube, and send the power value to the power adjustment module. Herein, the power control module may directly obtain a value of the first reference signal by using the detector or the coupler.

In a possible implementation of the second aspect, the signal apparatus further includes a radio frequency module and a baseband processing module, the power adjustment module is disposed in the baseband processing module, and the baseband processing module controls the radio frequency module to input a radio frequency signal to the input end of the traveling-wave tube. Herein, after functions of the power control module are integrated into the baseband processing module, hardware resource consumption of the entire signal apparatus can be reduced.

In a possible implementation of the second aspect, the signal apparatus includes N traveling-wave tubes, and N is an integer greater than or equal to 1. A quantity of power adjustment modules may be the same as or different from a quantity of traveling-wave tubes.

To be specific, in this embodiment of this application, the signal apparatus may include two traveling-wave tubes and one power adjustment module; or the signal apparatus may include two traveling-wave tubes and two power adjustment modules. Herein, when the quantity of power adjustment modules is less than the quantity of traveling-wave tubes, one power adjustment module may adjust collector voltages of a plurality of traveling-wave tubes, so that hardware resource consumption of the entire signal apparatus can be reduced. When the quantity of power adjustment modules is the same as the quantity of traveling-wave tubes, the power control module independently adjusts a collector voltage of each traveling-wave tube, so that power consumption of each traveling-wave tube can be more effectively reduced.

According to the signal apparatus in the second aspect of this application, the power adjustment module of the signal apparatus may search the mapping table for a corresponding collector voltage based on a reference signal currently input to the traveling-wave tube, to supply power to the collector of the traveling-wave tube. The collector voltage is adjusted within a preset value range of the collector voltage, so that a collector power that is of the traveling-wave tube and that corresponds to the collector voltage meets the preset working condition, and a correspondence between a reference signal and a collector voltage in the mapping table is updated, thereby dynamically adjusting the collector voltage of the traveling-wave tube and further reducing power consumption of the traveling-wave tube.

A third aspect of this application provides a signal apparatus, including a transceiver unit and a processing unit.

The transceiver unit is configured to obtain a first collector voltage value corresponding to a first reference signal; and
the processing unit is configured to:
determine whether working data of a collector of a traveling-wave tube meets a preset working condition when a voltage is provided for the collector by using the first collector voltage value; and
when the preset working condition is not met, adjust the first collector voltage value corresponding to the first reference signal in a preset mapping relationship to a second collector voltage value, where the working data of the collector meets the preset working condition when a voltage is provided for the collector by using the second collector voltage value.

A fourth aspect of this application provides a signal apparatus, including:
N traveling-wave tubes, where the traveling-wave tube includes a collector, and N is an integer greater than or equal to 1;
a processor, configured to perform the method for adjusting a collector voltage of a traveling-wave tube according to the first aspect; and
a memory, which may be coupled to or decoupled from a controller and is configured to store instructions executed by the controller.

A fifth aspect of this application provides a signal apparatus, including an input/output interface and a logic circuit.

The input/output interface is configured to obtain a first collector voltage value corresponding to a first reference signal; and
the logic circuit is configured to:
determine whether working data of a collector of a traveling-wave tube meets a preset working condition when a voltage is provided for the collector by using the first collector voltage value; and
when the preset working condition is not met, adjust the first collector voltage value corresponding to the first reference signal in a preset mapping relationship to a second collector voltage value, where the working data of the collector meets the preset working condition when a voltage is provided for the collector by using the second collector voltage value.

A sixth aspect of this application provides a computer-readable storage medium. The computer-readable storage medium includes instructions, and when the instructions are executed by a controller of a signal apparatus, the signal apparatus is enabled to implement the method for adjusting a collector voltage of a traveling-wave tube according to the first aspect.

A seventh aspect of this application provides a computer program product, including a non-volatile computer-readable storage medium. The non-volatile computer-readable storage medium includes computer program code used to perform the method for adjusting a collector voltage of a traveling-wave tube according to the first aspect.

### BRIEF DESCRIPTION OF DRAWINGS

FIG. 1 is a schematic diagram of a structure of a traveling-wave tube according to an embodiment of this application;
FIG. 2 is a schematic diagram of a structure of a signal apparatus including a traveling-wave tube according to an embodiment of this application;
FIG. 3 is a schematic diagram of a structure of a signal apparatus including a traveling-wave tube and a power adjustment module according to an embodiment of this application;
FIG. 4 is a schematic diagram of a structure of a base station including a signal apparatus according to an embodiment of this application;
FIG. 5 is a schematic diagram of a structure of a signal apparatus including a traveling-wave tube and a current detection module according to an embodiment of this application;
FIG. 6 is a flowchart of a method for adjusting a collector voltage of a traveling-wave tube according to an embodiment of this application;
FIG. 7 is a schematic diagram of a structure of a current detection module according to an embodiment of this application;
FIG. 8 is a schematic diagram of a structure of a signal apparatus including a traveling-wave tube and a power detection module according to an embodiment of this application;
FIG. 9 is a schematic diagram of a structure of a signal apparatus including a traveling-wave tube and a detector or a coupler according to an embodiment of this application;
FIG. 10 is a schematic diagram of a structure of another signal apparatus including a traveling-wave tube and a detector or a coupler according to an embodiment of this application;
FIG. 11 is a schematic diagram of a structure of a signal apparatus including a traveling-wave tube, a radio frequency module, and a baseband processing module according to an embodiment of this application;
FIG. 12 is a schematic diagram of a structure of a signal apparatus including two traveling-wave tubes and one power adjustment module according to an embodiment of this application; and
FIG. 13 is a schematic diagram of a structure of a signal apparatus including two traveling-wave tubes and two power adjustment modules according to an embodiment of this application.

### DESCRIPTION OF EMBODIMENTS

Embodiments of this application include but are not limited to a signal apparatus and a method for adjusting a collector voltage of a traveling-wave tube thereof. For ease of understanding the technical solutions of this application, the following first explains and describes technical terms related to the technical solutions of this application.

A traveling-wave tube is a power amplifying component that converts kinetic energy of a high-speed electron beam into energy of a microwave signal through interaction between the electron beam and the microwave signal. The traveling-wave tube has advantages such as a wide frequency band, a large gain, high efficiency, and a large output power, and is widely used in signal apparatuses of microwave communication.

The technical solutions of this application are applicable to communication fields such as 4G/5G mobile communication, internet of things communication, radar communication, and satellite communication. To make the objectives, technical solutions, and advantages of this application clearer, the following further describes the implementations of this application in detail with reference to the accompanying drawings.

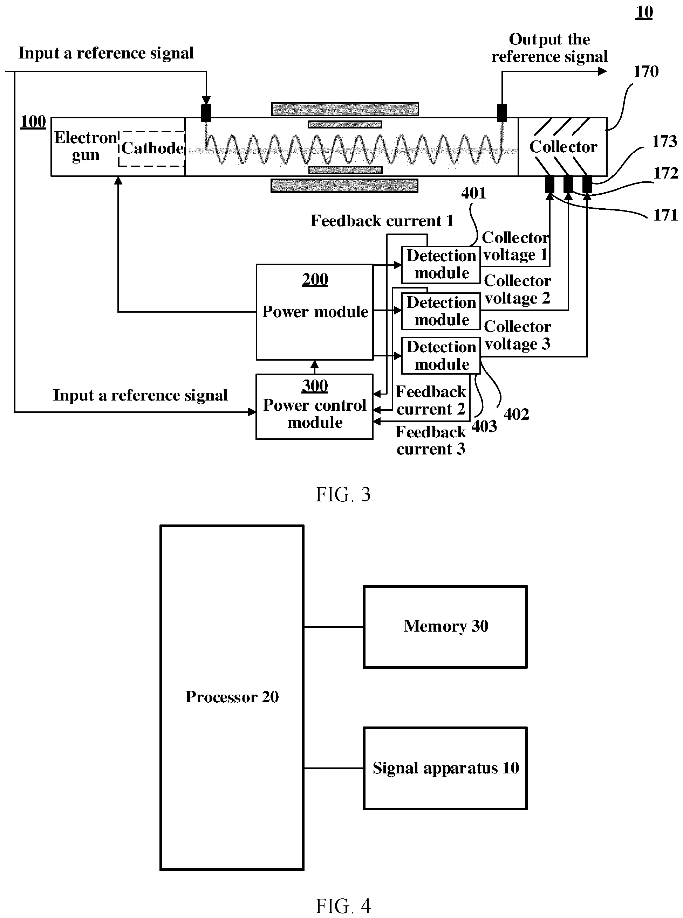

To resolve the problem of low efficiency of the traveling-wave tube 100 mentioned in FIG. 2, FIG. 3 provides a signal apparatus 10. As shown in FIG. 3, the signal apparatus 10 includes a traveling-wave tube 100, a power module 200, a power control module 300, and a detection module 401 to a detection module 403. In this embodiment of this application, the power control module 300 and the detection module 401 to the detection module 403 may be referred to as a power adjustment module.

Reference signals are separately input to the traveling-wave tube 100 and the power control module 300. The power control module 300 may store a mapping table between a reference signal and values of a collector voltage and a collector power. The collector power may be determined by using a collector voltage input by the power module 200 to a collector 170 of the traveling-wave tube 100 and a feedback current corresponding to the collector voltage. For a collector voltage that corresponds to each reference signal and that is applied to the collector 170 of the traveling-wave tube 100, the power control module 300 may adjust the collector voltage within a preset value range of the collector voltage, so that a collector power corresponding to the collector voltage reaches the minimum. The power control module 300 stores the minimum collector power, the collector voltage, and a value of the reference signal in the mapping table. When a reference signal is input to the traveling-wave tube 100, the power control module 300 searches, based on a value of the input reference signal, the mapping table for a collector voltage corresponding to the wave exit signal, and controls the power module 200 to apply the collector voltage to the collector 170 of the traveling-wave tube 100, so that a collector power of the collector 170 of the traveling-wave tube 100 reaches the minimum, thereby reducing power consumption of the traveling-wave tube 100.

The following uses the signal apparatus 10 in FIG. 3 as an example. A specific process in which the power control module 300 obtains the minimum collector power corresponding to the reference signal input to the traveling-wave tube 100 includes the following: The power control module 300 searches, based on the reference signal currently input to the traveling-wave tube 100, the mapping table stored in the power control module 300 for a preset collector voltage 1 to collector voltage 3 corresponding to the reference signal. The power control module 300 controls the power module 200 to apply the obtained collector voltage 1 to collector voltage 3 to an input end 171 to an input end 173 of the collector 170 of the traveling-wave tube 100, collects, by using the detection modules 401 to 403, a feedback current 1 to a feedback current 3 corresponding to the collector voltage 1 to the collector voltage 3 of the input end 171 to the input end 173 of the collector 170 of the traveling-wave tube 100, calculates a collector power 1 to a collector power 3 based on the collected feedback current 1 to feedback current 3 and the collector voltage 1 to the collector voltage 3, and temporarily stores the collector power 1 to the collector power 3. In addition, the power control module 300 sequentially and respectively adjusts the collector voltage 1 to the collector voltage 3 a plurality of times within preset adjustment ranges by using preset adjustment amplitudes, and calculates and stores, in real time, a total power of the collector that is obtained after each adjustment. For example, using the collector voltage 1 as an example, an adjustment range corresponding to the collector voltage 1 may be an interval of 10% above and below a value of the collector voltage 1. Assuming that the collector voltage 1 is 1000 V, the adjustment range corresponding to the collector voltage 1 may be [900 V, 1100 V], and an adjustment amplitude may be 20 V/time. In other words, the power control module 300 adjusts the collector voltage 1 within [900 V, 1100 V] by using the adjustment amplitude of 20 V/time, obtains a feedback current 1 that corresponds to the collector voltage 1 and that is obtained after each adjustment, and then calculates and temporarily stores a collector power 1 obtained after each adjustment. For the collector voltage 2 and the collector voltage 3, the power control module 300 may also calculate and temporarily store the collector power 2 and the collector power 3 by using a same method used for the collector voltage 1. Then the power control module 300 calculates sums of the collector powers 1 to the collector powers 3, namely, total powers, selects a collector voltage 1 to a collector voltage 3 with a minimum total power, establishes a mapping relationship between a reference signal, a collector voltage 1 to a collector voltage 3, and a total power, and supplements the mapping table with the mapping relationship or update the mapping relationship to the mapping table. The foregoing method for adjusting the collector voltage of the traveling-wave tube 100 can reduce power consumption of the traveling-wave tube 100.

It may be understood that in this embodiment of this application, as shown in FIG. 3, an example in which three input ends, namely, the input end 171 to the input end 173, are disposed on the collector 170 of the traveling-wave tube 100 is used for description. In another embodiment of this application, any quantity of input ends, for example, four input ends, namely, an input end 171 to an input end 174, may alternatively be disposed on the collector 170 of the traveling-wave tube 100. This is not limited in this application.

The signal apparatus 10 in this embodiment of this application may be applied to various electronic devices. For example, the electronic devices include but are not limited to a radio frequency/microwave/millimeter-wave and terahertz (Tera Hertz, THz) base station, network server, signal server, and another electronic device that communicates a reference signal through an antenna. An example in which the electronic device is a base station is used for description in embodiments of this application. FIG. 4 is a schematic diagram of a structure of a base station according to an embodiment of this application. The base station includes a signal apparatus 10, a processor 20, and a memory 30.

The signal apparatus 10 is configured to send reference signals such as a radio frequency signal/a microwave signal/a millimeter-wave signal and a terahertz signal to user equipment, so that data transmission and an audio call/a video call can be implemented between the user equipment and the base station.

The processor 20 may include one or more processing units. For example, the processor 20 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a neural-network processing unit (neural-network processing unit, NPU), and/or the like. Different processing units may be independent components, or may be integrated into one or more processors.

The memory 30 may be configured to store computer-executable program code, and the executable program code includes instructions. The memory 30 may include a program storage area and a data storage area. The program storage area may store an operating system and an application required by at least one function. The data storage area may store data created during use of the base station. In this embodiment of this application, the memory 30 may store a mapping table between a collector voltage and a reference signal, and an adjustment range threshold and an adjustment amplitude of the collector voltage.

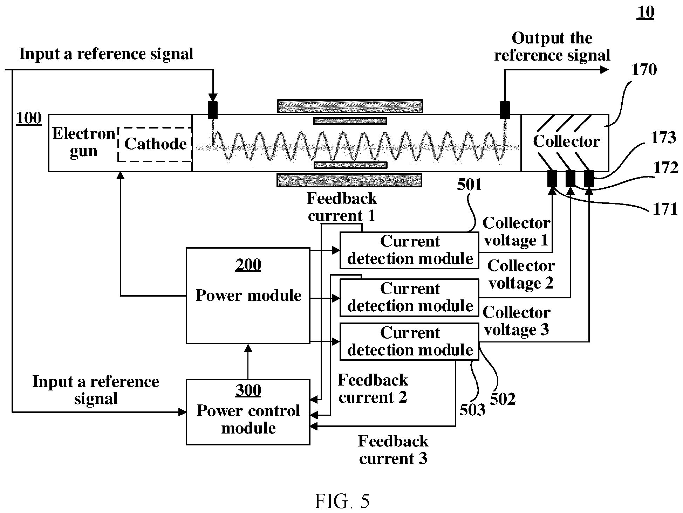

The following describes the solutions of this application by describing functions of components in a signal apparatus 10 in FIG. 5. Differences between the signal apparatus 10 in FIG. 5 and the signal apparatus 10 in FIG. 3 are as follows: A current detection module 501 to a current detection module 503 are disposed in the signal apparatus 10 in FIG. 5. The current detection module 501 to the current detection module 503 may be used as specific implementations of the detection module 401 to the detection module 403, and are configured to directly obtain a feedback current 1 to a feedback current 3 corresponding to a collector voltage 1 to a collector voltage 3 that are input by a power module 200 to an input end 171 to an input end 173 of a collector 170 of a traveling-wave tube 100, and send the feedback current 1 to the feedback current 3 to a power control module 300. The power control module 300 calculates a collector power of the collector 170 based on the collector voltage 1 to the collector voltage 3 and the feedback current 1 to the feedback current 3. The solution of the signal apparatus 10 in FIG. 5 in this application may be implemented by a processor 20 of a base station by controlling the power control module 300 to execute a related program.

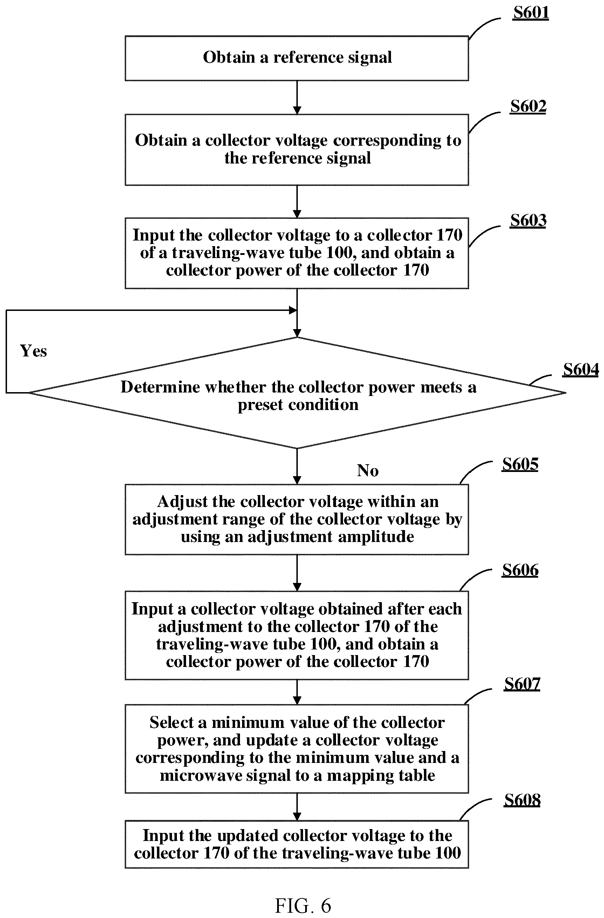

Specifically, as shown in FIG. 6, an adjustment method of the signal apparatus 10 includes the following steps.

S601: Obtain a reference signal.

As shown in FIG. 5, the power control module 300 may be connected to an input energy transmission window 120 of the traveling-wave tube 100, to obtain a to-be-amplified reference signal input to the input energy transmission window 120 of the traveling-wave tube 100. In another embodiment of this application, alternatively, the reference signal may be an amplified reference signal output from an output energy transmission window 130 of the traveling-wave tube 100, or may be a power back-off signal of the traveling-wave tube 100.

S602: Obtain a collector voltage corresponding to the reference signal.

Using the to-be-amplified reference signal input to the traveling-wave tube 100 as an example, when the reference signal is input to the traveling-wave tube 100, the power control module 300 may obtain a value corresponding to the reference signal, and find a collector voltage corresponding to the reference signal in a mapping table that is between a collector voltage and a reference signal and that is stored in a memory 30 of the base station. For example, Table 1 shows a mapping table between a reference signal input to the traveling-wave tube 100 in the signal apparatus 10 shown in FIG. 5 and a collector voltage.

**Table 1**

| Reference signal | Collector voltage 1 | Collector voltage 2 | Collector voltage 3 |
|---|---|---|---|
| 20 dBm | 5000 V | 2100 V | 400 V |
| 25 dBm | 6000 V | 3000 V | 500 V |

In FIG. 5, the collector 170 of the traveling-wave tube 100 of the signal apparatus 10 includes three input ends: the input end 171 to the input end 173. Therefore, the power control module 300 needs to obtain, from the mapping table described in Table 1 based on the reference signal input to the traveling-wave tube 100, a collector voltage 1 to a collector voltage 3 respectively applied to the input end 171 to the input end 173. The collector voltage 1 to the collector voltage 3 may be denoted as *V*₁₇₁1, *V*₁₇₂1, and *V*₁₇₃1. As shown in Table 1, when the reference signal is 20 dBm, the collector voltage 1 to the collector voltage 3 are respectively 5000 V, 2100 V, and 400 V (V, volt, voltage unit).

In another embodiment of this application, after the power control module 300 obtains the reference signal input to the traveling-wave tube 100, if the power control module 300 cannot directly find a mapping relationship between the reference signal and a collector voltage in the mapping table stored in the memory 30, the power control module 300 may search the mapping table for a mapping relationship between a reference signal whose value is closest to that of the reference signal and a collector voltage, use the mapping relationship as a mapping relationship between the current reference signal and a collector voltage, and adds the mapping relationship to the mapping table stored in the memory 30. For example, when the reference signal is 24 dBm, the power control module 300 may determine, based on values of reference signals in Table 1, that a reference signal closest to the reference signal 24 dBm is 25 dBm. As shown in Table 2, the power control module 300 adds a collector voltage 1 to a collector voltage 3 corresponding to the reference signal 25 dBm to the mapping table as a collector voltage 1 to a collector voltage 3 of the reference signal 24 dBm.

**Table 2**

| Reference signal | Collector voltage 1 | Collector voltage 2 | Collector voltage 3 |
|---|---|---|---|
| 20 dBm | 5000 V | 2100 V | 400 V |
| 24 dBm | 6000 V | 3000 V | 500 V |
| 25 dBm | 6000 V | 3000 V | 500 V |

S603: Input the collector voltage to the collector 170 of the traveling-wave tube 100, and obtain a collector power of the collector 170.

After the power control module 300 finds the collector voltage 1 to the collector voltage 3 corresponding to the reference signal, the power control module 300 controls the power module 200 to apply the found collector voltage 1 to collector voltage 3 to the input end 171 to the input end 173 of the collector 170 of the traveling-wave tube 100. Herein, the collector voltage 1 to the collector voltage 3 that are applied by the power module 200 to the traveling-wave tube 100 may reach the input end 171 to the input end 173 of the collector 170 through the current detection module 501 to the current detection module 503 between the power module 200 and the input end 171 to the input end 173. In addition, the current detection module 501 to the current detection module 503 may further obtain a feedback current 1 to a feedback current 3 corresponding to the collector voltage 1 to the collector voltage 3 of the input end 171 to the input end 173, and send the feedback current 1 to the feedback current 3 to the power control module 300.

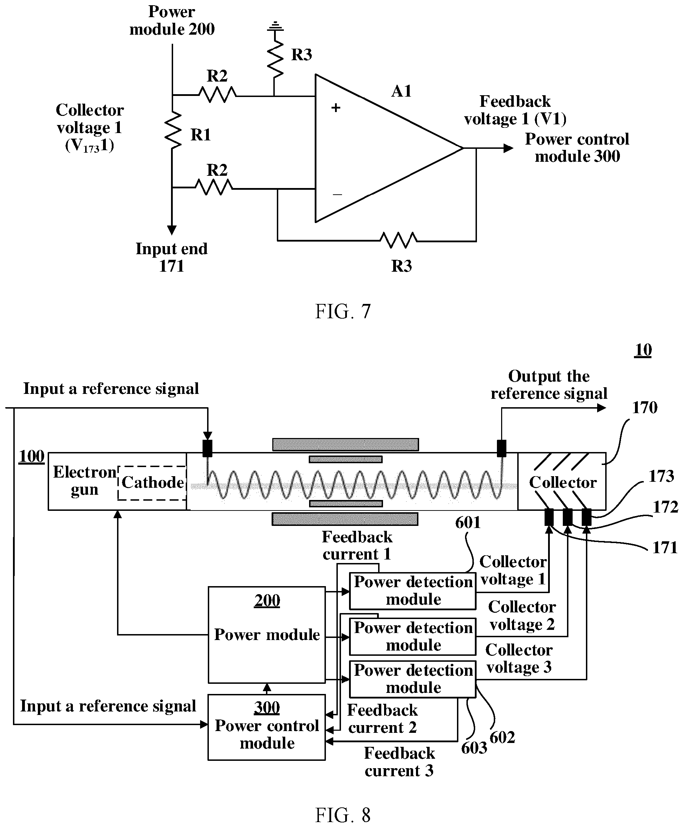

In this embodiment of this application, the current detection module 501 is used as an example. As shown in FIG. 7, the current detection module 501 may include a resistor R1 to a resistor R3 and an operational amplifier A1. The current detection module 501 is separately connected to the power module 200, the input end 171 of the collector 170, and the power control module 300, and obtains a feedback voltage V1 by using a collector voltage 1 *V*₁₇₁1 applied by the power module 200 to the input end 171 of the collector 170. After obtaining the feedback voltage V1, the current detection module 501 first calculates, by using Formula (1), a feedback current 1 corresponding to the collector voltage 1: Feedback current 1 (I1)=R2*V1/(R1*R3), and then the current detection module 501 sends the feedback current 1 to the power control module 300. The power control module 300 calculates, by using Formula (2), a collector power 1 corresponding to the collector voltage 1: Collector power=Feedback current*Collector voltage.

For example, when the reference signal is 20 dBm, the collector voltage 1 is 5000 V In this case, a resistance R1 to a resistance R3 are respectively 2 S2, 10 S2, and 2000 S2 (S2, ohm, resistance unit). The power control module 300 may calculate, according to Formula (1) and Formula (2), that the collector power 1 corresponding to the collector voltage 1 is 62500 W (W, watt, power unit). It may be understood that values of the resistance R1 to the resistance R3 are examples. In another embodiment of this application, the values of the resistance R1 to the resistance R3 may alternatively be in another unit.

Similarly, in addition to the current detection module 501, the current detection module 502 and the current detection module 503 may also use a same method as the current detection module 501 to respectively obtain a feedback voltage V2 and a feedback voltage V3 corresponding to the collector voltage 2 and the collector voltage 3. The power control module 300 calculates, based on the feedback voltage V2 and the feedback voltage V3, a collector power 2 and a collector power 3 corresponding to the collector voltage 2 and the collector voltage 3. For example, the collector voltage 2 is 2100 V, and the collector power 2 is 11025 W; and the collector voltage 3 is 400 V, and the collector power 3 is 400 W.

After calculating the collector power 1 to the collector power 3 corresponding to the collector voltage 1 to the collector voltage 3, the power control module 300 calculates and stores a total power of the input end 171 to the input end 173 of the collector 170, namely, a sum of the collector power 1 to the collector power 3.

S604: Determine whether the collector power meets a preset working condition.

When the collector power does not meet the preset working condition, S605 is performed to adjust a value of the collector voltage, so that the collector power meets the preset working condition.

The collector power herein may be a total power of the collector 170 of the traveling-wave tube 100. The preset working condition may be that a current total power of the collector 170 of the traveling-wave tube 100 does not meet a preset total power threshold. The memory 30 of the base station stores a mapping table between a reference signal and a total power threshold of the collector in addition to the mapping table between a reference signal and a collector voltage. After the power control module 300 controls the power module 200 to apply the collector voltage corresponding to the reference signal to the collector 170 of the traveling-wave tube 100, the power control module 300 may obtain the total power of the collector 170. When the total power is less than a total power threshold that is of the collector and that corresponds to the reference signal, S605 is performed, to be specific, the power control module 300 controls the power module 200 to adjust the collector voltage applied to the collector 170 of the traveling-wave tube 100.

For example, in an example in which the collector power 1 is 62500 W, the collector power 2 is 11025 W, and the collector power 3 is 400 W in S603, a current total power of the collector is 73925 W. In a preset working condition, in other words, in a case of a total power threshold of 70000 W, the power control module 300 may determine that the collector power does not meet the preset working condition.

S605: Adjust the collector voltage within an adjustment range of the collector voltage by using an adjustment amplitude.

The power control module 300 first determines the adjustment range of the collector voltage. The adjustment range herein may be determined by using the value of the collector voltage and an adjustment range threshold. For example, the adjustment range of the collector voltage is determined by using a sum and a difference of a value determined by multiplying the value of the collector voltage by the adjustment range threshold and the value of the collector voltage. The collector voltage 1 is 5000 V, the adjustment range threshold is 10%, and a product of the value of the collector voltage and the adjustment range threshold is 500 V Therefore, an adjustment range of the collector voltage 1 may be [5000 V 500 V, 5000 V+500 V], that is, [4500 V, 5500 V]. The adjustment amplitude herein may be a value added to or subtracted from the value of the collector voltage each time the value of the collector voltage is adjusted, and a value of an adjusted collector voltage needs to fall within the adjustment range. For example, the adjustment amplitude may be 100 V/time. To be specific, each time the value of the collector voltage is adjusted, 100 V is added to or subtracted from the value of the collector voltage. For example, the collector voltage 1 is 5000 V When the adjustment range is [4500 V, 5500 V], and the adjustment amplitude is 100 V/time, the power control module 300 separately adjusts the collector voltage 1 to values of 10 collector voltages 1, for example, 4500 V, 4600 V, 4700 V, ..., and 5500 V

It may be understood that in addition to adjusting the collector voltage 1, the power control module 300 may separately adjust the collector voltage 2 and the collector voltage 3 by using a same method used for the collector voltage 1. For example, for the collector voltage 2 and the collector voltage 3, when the adjustment range threshold is 10%, an adjustment range of the collector voltage 2 may be [1890 V, 2310 V], and an adjustment range of the collector voltage 3 may be [360 V, 440 V]. Adjustment amplitudes of the collector voltage 2 and the collector voltage 3 may be the same as or different from the adjustment amplitude of the collector voltage 1.

S606: Input a collector voltage obtained after each adjustment to the collector 170 of the traveling-wave tube 100, and obtain a collector power of the collector 170.

Herein, the power control module 300 may use the method described in S603 to calculate the collector power corresponding to the collector voltage obtained after each adjustment. This is not specifically described herein. For example, for an adjusted collector voltage 1, the power control module 300 separately calculates collector powers corresponding to the values of the 10 collector voltages 1, for example, 4500 V, 4600 V, 4700 V, ..., and 5500 V, obtained in step S605. Using 4500 V as an example, a collector power corresponding to the collector voltage 1 is 50625 W.

Similarly, the power control module 300 may further separately calculate a collector power 2 and a collector power 3 corresponding to a collector voltage 2 and a collector voltage 3 obtained after each adjustment.

S607: Select a minimum value of the collector power, and update a collector voltage corresponding to the minimum value and the reference signal to the mapping table.

Herein, the power control module 300 may store a calculated collector power corresponding to a collector voltage obtained after each adjustment, select a minimum value of the collector power from a plurality of collector powers, set the minimum value of the collector power as a preset condition of the collector power, namely, a mapping relationship between a current reference signal and a total power threshold of the collector, and update the mapping relationship to the mapping table between a reference signal and a total power threshold of the collector.

In addition, the collector voltage corresponding to the minimum value of the collector power is updated to the mapping table between a reference signal and a collector voltage.

For example, as described in Table 3, in an example in which adjusted collector voltages 1 are 10 values such as 4500 V, 4600 V, 4700 V, ..., and 5500 V, the power control module 300 may select a minimum value 50625 W of the collector power of the collector voltage 1, and update, to the mapping table between a reference signal and a collector voltage, a case in which a collector voltage 1 corresponding to 50625 W is equal to 4500 V Similarly, for the collector voltage 2 and the collector voltage 3, the power control module 300 may also select minimum values of the collector power 2 and the collector power 3, and update a collector voltage 2 and a collector voltage 3 corresponding to the minimum values to the mapping table.

**Table 3**

| Reference signal | Collector voltage 1 | Collector voltage 2 | Collector voltage 3 |
|---|---|---|---|
| 20 dBm | 4500 V | 1890 V | 360 V |
| 24 dBm | 6000 V | 3000 V | 500 V |
| 25 dBm | 6000 V | 3000 V | 500 V |

S608: Input the updated collector voltage to the collector 170 of the traveling-wave tube 100.

Herein, the power control module 300 re-obtains, based on the updated mapping table between a reference signal and a collector voltage, a collector voltage corresponding to the current reference signal, and controls the power module 200 to apply the re-obtained collector voltage to the collector of the traveling-wave tube.

It may be understood that in addition to adjusting the collector voltage of the traveling-wave tube 100 in real time, the power control module 300 of the signal apparatus 10 in FIG. 5 may further run in two modes: a training mode and a working mode. In the training mode, the power control module 300 may perform steps S601 to S607 in FIG. 6, to be specific, train and update, based on a current reference signal (including an input reference signal, an output reference signal, and a power back-off signal), the mapping table that is between a reference signal and a collector voltage and that is stored in the power control module 300, so that an optimal adjustment to a collector voltage corresponding to the reference signal is implemented, thereby improving efficiency of the traveling-wave tube 100. In the working mode, the power control module 300 may perform steps S601 and S602 in FIG. 6, to be specific, obtain, based on a current reference signal, a collector voltage corresponding to the current reference signal from the stored mapping table between a reference signal and a collector voltage, and control the power module 200 to output the obtained collector voltage to the collector 170 of the traveling-wave tube 100.

In this embodiment of this application, the power control module 300 may distinguish between the training mode and the working mode by using workload of the signal apparatus 10. For example, the power control module 300 stores a load threshold that indicates workload of the signal apparatus 10, and the load threshold may be 40%. When the workload of the signal apparatus 10 is less than 40%, the power control module 300 switches to the training mode; and when the workload of the signal apparatus 10 is greater than 40%, the power control module 300 switches to the working mode. Through switching between the training mode and the working mode of the signal apparatus 10, when the workload of the signal apparatus 10 is relatively high, the signal apparatus 10 remains in the working mode, to avoid impact on normal working of the signal apparatus 10 that is caused after the signal apparatus 10 is switched to the training mode.

It may be understood that in another embodiment of this application, the power control module 300 may distinguish between the training mode and the working mode depending on whether working time of the signal apparatus 10 falls within a preset time range. For example, the preset time range may be from midnight to six o'clock of the next day. When the working time of the signal apparatus 10 falls within the preset time range, the power control module 300 determines that the signal apparatus 10 works in a non-busy time period. After the power control module 300 switches the signal apparatus 10 to the training mode, impact on normal working of the signal apparatus can be avoided.

FIG. 8 shows another embodiment of a signal apparatus 10 according to this application. The following describes a solution of this embodiment by describing differences between the signal apparatus 10 in FIG. 8 and the signal apparatus 10 in FIG. 3. The differences between the signal apparatus 10 in FIG. 8 and the signal apparatus 10 in FIG. 3 are as follows: A power detection module 601 to a power detection module 603 are disposed in the signal apparatus 10 in FIG. 8. The power detection module 601 to the power detection module 603 may be used as specific implementations of the detection module 401 to the detection module 403, and are configured to: after obtaining a feedback current 1 to a feedback current 3 corresponding to a collector voltage 1 to a collector voltage 3 that are input by a power module 200 to an input end 171 to an input end 173 of a collector 170 of a traveling-wave tube 100, calculate a collector power 1 to a collector power 3 by using a calculation method of Collector power=Feedback current*Collector voltage, and send the collector power 1 to the collector power 3 to a power control module 300. The power control module 300 calculates a collector power of the collector 170 based on the collector power 1 to the collector power 3.

It may be understood that for the signal apparatus 10 in the embodiment shown in FIG. 8, the power control module 300 may alternatively directly calculate a collector power of the traveling-wave tube 100 by using a power detection module, to reduce complexity of performing, by the power control module 300, a method for adjusting a collector voltage of the collector of the traveling-wave tube 100.

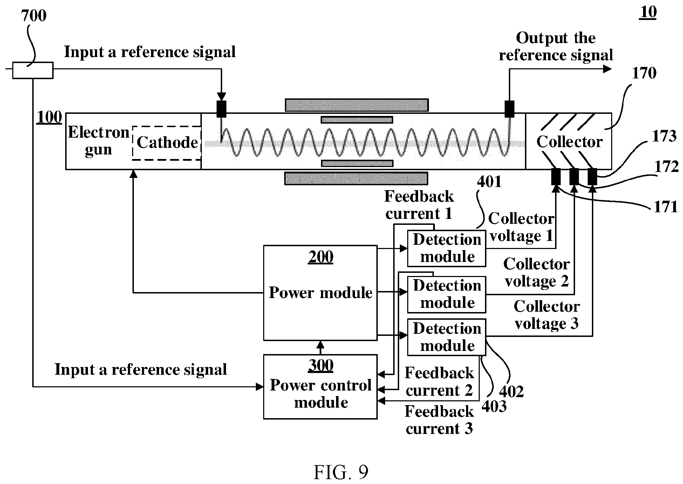

FIG. 9 shows another embodiment of a signal apparatus 10 according to this application. The following describes a solution of this embodiment by describing differences between the signal apparatus 10 in FIG. 9 and the signal apparatus 10 in FIG. 3. The differences between the signal apparatus 10 in FIG. 8 and the signal apparatus 10 in FIG. 3 are as follows: In FIG. 9, the signal apparatus 10 includes a detector 700, configured to obtain a value of a reference signal. The reference signal is input to a traveling-wave tube 100 after passing through the detector 700. In addition, the detector 700 is connected to a power control module 300, and the power control module 300 may obtain, in real time by using the detector 700, the reference signal input to the traveling-wave tube 100. The detector 700 herein may alternatively be a coupler.

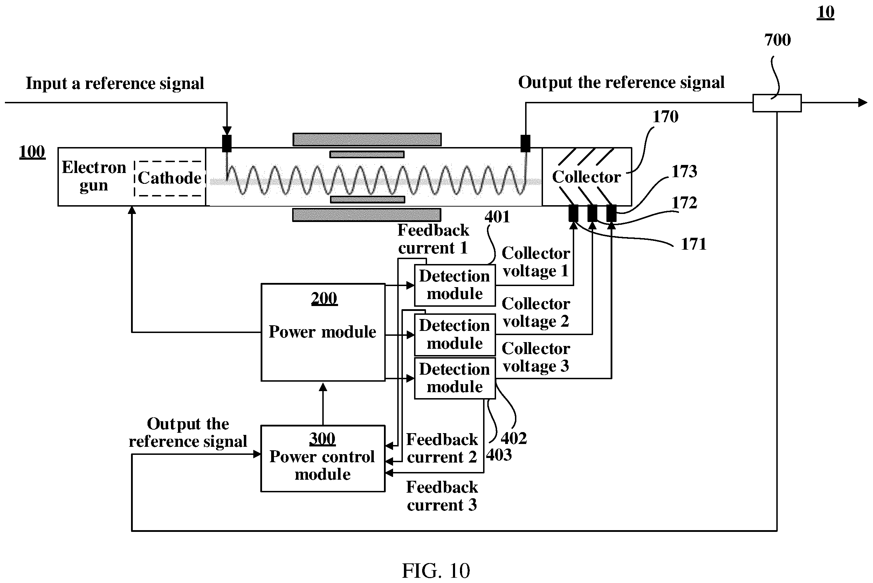

FIG. 10 shows another embodiment of a signal apparatus 10 according to this application. The following describes a solution of this embodiment by describing differences between the signal apparatus 10 in FIG. 10 and the signal apparatus 10 in FIG. 9. The differences between the signal apparatus 10 in FIG. 10 and the signal apparatus 10 in FIG. 9 are as follows: In FIG. 9, a detector 700 of the signal apparatus 10 is disposed at a location at which a traveling-wave tube 100 outputs a reference signal. In addition, the detector 700 is communicatively connected to a power control module 300, and the power control module 300 may obtain, in real time by using the detector 700, the reference signal output by the traveling-wave tube 100.

It may be understood that for the signal apparatus 10 in the embodiment shown in FIG. 10, the power control module 300 may further determine and adjust a collector voltage of the traveling-wave tube 100 based on the reference signal output by the traveling-wave tube 100, to improve flexibility of adjusting the collector voltage of the traveling-wave tube 100.

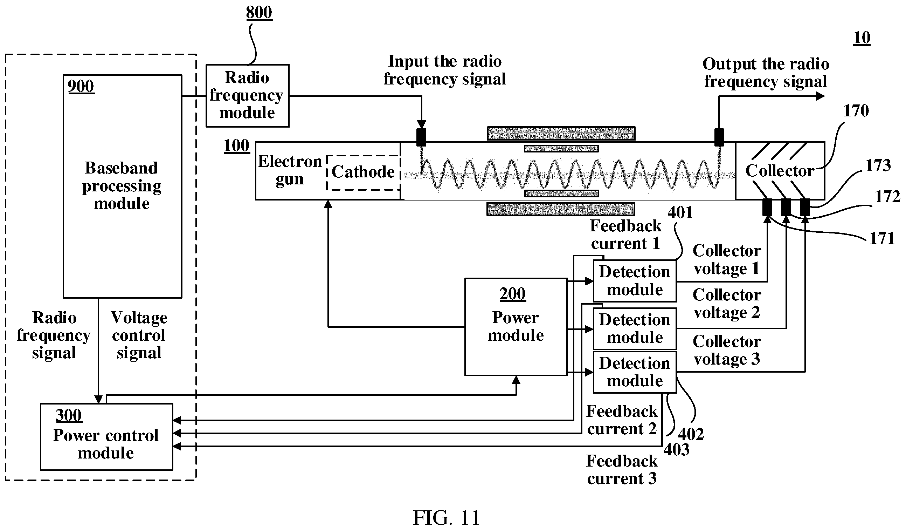

FIG. 11 shows another embodiment of a signal apparatus 10 according to this application. The following describes a solution of this embodiment by describing differences between the signal apparatus 10 in FIG. 11 and the signal apparatus 10 in FIG. 3. The differences between the signal apparatus 10 in FIG. 11 and the signal apparatus 10 in FIG. 3 are as follows: In FIG. 11, the signal apparatus 10 includes a radio frequency module 800 and a baseband processing module 900, and the baseband processing module 900 is configured to control the radio frequency module 800 to input a radio frequency signal, namely, a reference signal, to a traveling-wave tube 100. In addition, the baseband processing module 900 may be further communicatively connected to a power control module 300, and send a value of the radio frequency signal to the power control module 300. The baseband processing module 900 may further send a voltage control signal to the power control module 300, and the power control module 300 controls, based on the received voltage control signal, a power module 200 to apply a voltage to the traveling-wave tube 100.

It may be understood that in the embodiment shown in FIG. 11, the power control module 300 may be directly integrated into the baseband processing module 900, so that the baseband processing module 900 can directly send the voltage control signal to the power module 200, to control the power module 200 to apply the voltage to the traveling-wave tube 100. In an embodiment in which the power control module 300 is integrated into the baseband processing module 900 shown in FIG. 11, after functions implemented by the power control module 300 are integrated into the baseband processing module 900, hardware resource consumption of the entire signal apparatus 10 can be reduced.

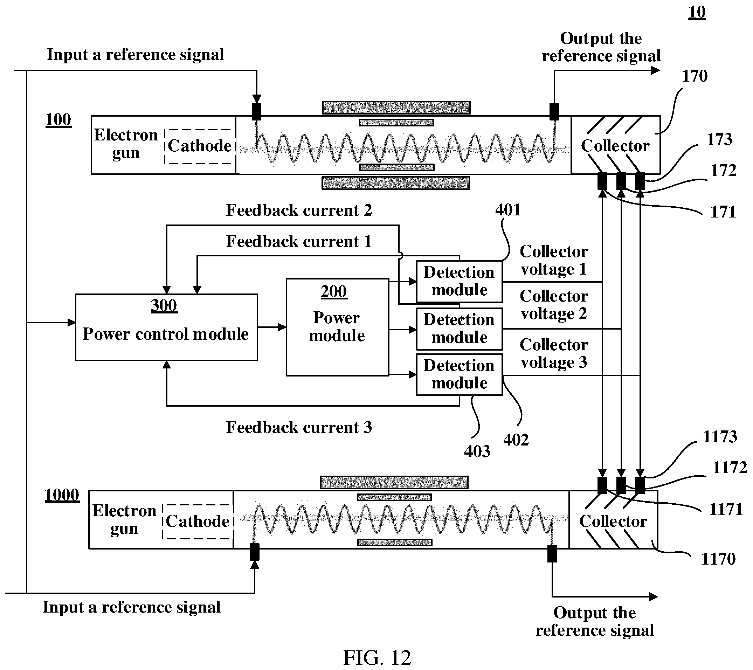

FIG. 12 shows another embodiment of a signal apparatus 10 according to this application. The following describes a solution of this embodiment by describing differences between the signal apparatus 10 in FIG. 12 and the signal apparatus 10 in FIG. 3. The differences between the signal apparatus 10 in FIG. 12 and the signal apparatus 10 in FIG. 3 are as follows: In FIG. 12, the signal apparatus 10 includes a traveling-wave tube 100 and a traveling-wave tube 1000, and a power control module 300 separately inputs reference signals of the traveling-wave tube 100 and the traveling-wave tube 1000. Herein, values of the reference signals input to the traveling-wave tube 100 and the traveling-wave tube 1000 may be the same or different. The power control module 300 controls a power module 200 to simultaneously apply an obtained collector voltage 1 to collector voltage 3 to an input end 171 to an input end 173 of a collector 170 of the traveling-wave tube 100 and an input end 1171 to an input end 1173 of a collector 1170 of the traveling-wave tube 1000. The power control module 300 may determine the collector voltage 1 to the collector voltage 3 herein based on a mapping table between values of the reference signals input to the traveling-wave tube 100 and the traveling-wave tube 1000 and collector voltages. In other words, the power control module 300 may search the mapping table for corresponding collector voltages based on the values of the reference signals input to the traveling-wave tube 100 and the traveling-wave tube 1000. In addition, the power control module 300 collects, by using detection modules 401 to 403, a feedback current 1 to a feedback current 3 corresponding to the collector voltage 1 to the collector voltage 3 of the input end 171 to the input end 173 of the collector 170 of the traveling-wave tube 100 and the input end 1171 to the input end 1173 of the collector 1170 of the traveling-wave tube 1000, calculates a collector power 1 to a collector power 3 based on the collected feedback current 1 to feedback current 3 and the collector voltage 1 to the collector voltage 3, and then calculates total powers of the traveling-wave tube 100 and the traveling-wave tube 1000.

It may be understood that for the signal apparatus 10 in the embodiment shown in FIG. 12, the power module 200 may simultaneously supply power to collectors of a plurality of traveling-wave tubes of a same specification, and may use a sum of total powers of the plurality of traveling-wave tubes as a total power of the signal apparatus 10, and adjust collector voltages of the plurality of traveling-wave tubes together by using the method shown in FIG. 6, so that a process of adjusting the collector voltages can be simplified, and hardware resource consumption of the entire signal apparatus 10 can be reduced.

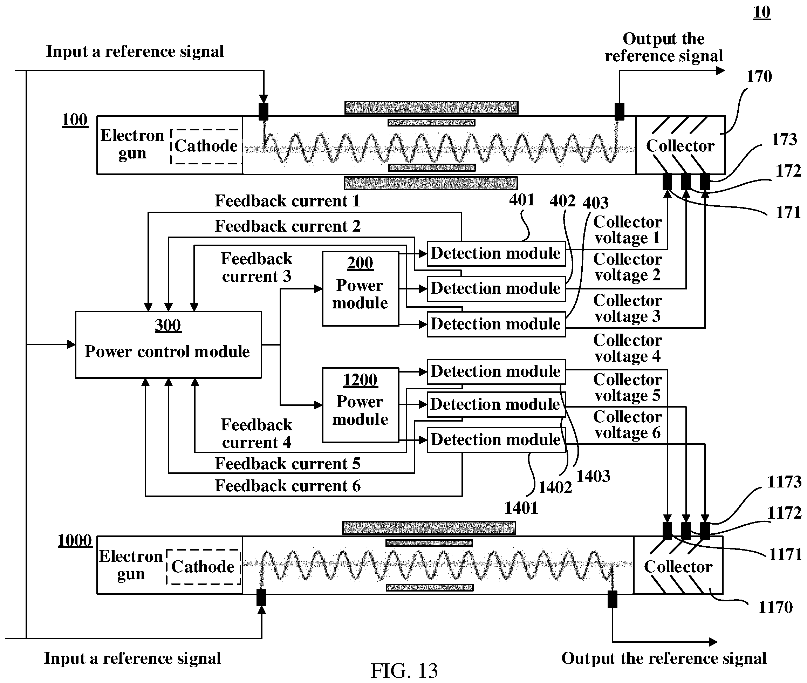

FIG. 13 shows another embodiment of a signal apparatus 10 according to this application. The following describes a solution of this embodiment by describing differences between the signal apparatus 10 in FIG. 13 and the signal apparatus 10 in FIG. 12. The differences between the signal apparatus 10 in FIG. 13 and the signal apparatus 10 in FIG. 12 are as follows: In FIG. 13, the signal apparatus 10 includes a power module 200, a detection module 401 to a detection module 403, a power module 2000, and a detection module 1401 to a detection module 1403. The detection module 401 to the detection module 403 are connected to an input end 171 to an input end 173 of a collector 170 of a traveling-wave tube 100, and the detection module 1401 to the detection module 1403 are connected to an input end 1171 to an input end 1173 of a collector 1170 of a traveling-wave tube 1000. A power control module 300 controls, based on reference signals currently separately input to the traveling-wave tube 100 and the traveling-wave tube 1000, a power module 200 to apply a collector voltage 1 to a collector voltage 3 to the input end 171 to the input end 173 of the collector 170 of the traveling-wave tube 100, and apply a collector voltage 4 to a collector voltage 6 to the input end 1171 to the input end 1173 of the collector 1170 of the traveling-wave tube 1000. In addition, the power control module 300 collects, by using the detection modules 401 to 403, a feedback current 1 to a feedback current 3 corresponding to the collector voltage 1 to the collector voltage 3 of the input end 171 to the input end 173 of the collector 170 of the traveling-wave tube 100, and calculates a collector power 1 to a collector power 3 of the traveling-wave tube 100 based on the collected feedback current 1 to feedback current 3 and the collector voltage 1 to the collector voltage 3; and collects, by using the detection modules 1401 to 1403, a feedback current 4 to a feedback current 6 corresponding to the collector voltage 4 to the collector voltage 6 of the input end 1171 to the input end 1173 of the collector 1170 of the traveling-wave tube 1000, and calculates a collector power 4 to a collector power 6 of the traveling-wave tube 1000 based on the collected feedback current 4 to feedback current 6 and the collector voltage 4 to the collector voltage 6. Then the power control module 300 may separately calculate total powers of the traveling-wave tube 100 and the traveling-wave tube 1000.

It may be understood that for the signal apparatus 10 in the embodiment shown in FIG. 13, an independent power module is configured for each traveling-wave tube in the signal apparatus 10 to supply power separately. In addition, an independent detection module is also configured for a collector of each traveling-wave tube. The power control module 300 may independently adjust a collector voltage of each traveling-wave tube by using the power module and the detection module of each traveling-wave tube, so that power consumption of each traveling-wave tube in the signal apparatus 10 can be more effectively reduced.

It should be understood that although terms such as "first" and "second" may be used herein to describe various features, these features should not be limited by these terms. These terms are merely used for distinction, and shall not be understood as an indication or implication of relative importance. For example, without departing from the scope of the example embodiments, a first feature may be referred to as a second feature, and similarly, the second feature may be referred to as the first feature.

Furthermore, various operations will be described as a plurality of separate operations in a manner that is most conducive to understanding illustrative embodiments. However, a described sequence should not be construed as implying that these operations need to depend on the described sequence. Many of these operations may be performed in parallel, concurrently, or simultaneously. In addition, the sequence of the operations may be further rearranged. The processing may be terminated when the described operations are completed, but additional operations not included in the accompanying drawings may be further included. The processing may correspond to a method, a function, a procedure, a subroutine, a subprogram, or the like.

References to "an embodiment", "embodiments", "an illustrative embodiment", and the like in the specification indicate that the described embodiment may include a specific feature, structure, or property, but each embodiment may or may not necessarily include the specific feature, structure, or property. In addition, these phrases are not necessarily intended for a same embodiment. In addition, when specific features are described with reference to specific embodiments, knowledge of a person skilled in the art can affect combination of these features with other embodiments, regardless of whether these embodiments are explicitly described.

Unless otherwise stated, terms "contain", "have", and "include" are synonymous. A phrase "A/B" indicates "A or B". The phrase "A and/or B" indicates "(A), (B), or (A and B)".

As used herein, the term "module" may refer to being a part thereof, or include a memory (a shared memory, a dedicated memory, or a group memory) for running one or more software or firmware programs, an application-specific integrated circuit (ASIC), an electronic circuit and/or a processor (a shared processor, a dedicated processor, or a group processor), a combinatorial logic, and/or another proper component that provides the function.

In the accompanying drawings, some structure or method features may be shown in a specific arrangement and/or order. However, it should be understood that such a specific arrangement and/or order is not mandatory. In some embodiments, these features may be described in a manner and/or order different from that shown in the descriptive accompanying drawings. In addition, structure or method features included in a specific accompanying drawing do not mean that all embodiments need to include such features. In some embodiments, these features may not be included, or these features may be combined with other features.

Embodiments of this application are described above in detail with reference to the accompanying drawings. However, use of the technical solutions of this application is not limited to various applications mentioned in embodiments of this patent, and various structures and variations may be easily implemented with reference to the technical solutions of this application, to achieve various beneficial effects mentioned in this specification. Without departing from the purpose of this application, any variation made within the scope of knowledge possessed by a person of ordinary skill in the art shall fall within the scope of the patent of this application.

## Claims

1. A method for adjusting a collector voltage of a traveling-wave tube, applied to a signal apparatus comprising a traveling-wave tube, wherein the method comprises:
obtaining a first collector voltage value corresponding to a first reference signal;
determining whether working data of a collector of the traveling-wave tube meets a preset working condition when a voltage is provided for the collector by using the first collector voltage value; and
when the preset working condition is not met, adjusting the first collector voltage value corresponding to the first reference signal in a preset mapping relationship to a second collector voltage value, wherein the working data of the collector meets the preset working condition when a voltage is provided for the collector by using the second collector voltage value.

2. The method according to claim 1, wherein the preset working condition is a preset working data threshold of the collector.

3. The method according to claim 2, wherein the working data comprises a working current or a power of the collector, and the preset working data threshold comprises a preset current threshold or a preset power threshold.

4. The method according to claim 1, wherein the adjusting the first collector voltage value corresponding to the first reference signal in a preset mapping relationship to a second collector voltage value comprises:
determining an adjustment range of the first collector voltage value based on a preset value; and
selecting, from the adjustment range, a voltage value that meets the preset working condition as the second collector voltage value.

5. The method according to claim 4, wherein the selecting, from the adjustment range, a voltage value that meets the preset working condition as the second collector voltage value comprises:
when a plurality of voltage values within the adjustment range meet the preset working condition, selecting a voltage value corresponding to minimum power consumption of the collector as the second collector voltage value.

6. The method according to claim 1, wherein the first reference signal comprises any one of a reference signal input to the traveling-wave tube, a reference signal output by the traveling-wave tube, and a power back-off signal of the traveling-wave tube.

7. A signal apparatus, comprising a traveling-wave tube and a power adjustment module, wherein
the power adjustment module is configured to:
obtain a first collector voltage value corresponding to a first reference signal;
determine whether working data of a collector of the traveling-wave tube meets a preset working condition when a voltage is provided for the collector by using the first collector voltage value; and
when the preset working condition is not met, adjust the first collector voltage value corresponding to the first reference signal in a preset mapping relationship to a second collector voltage value, wherein the working data of the collector meets the preset working condition when a voltage is provided for the collector by using the second collector voltage value.

8. The signal apparatus according to claim 7, wherein the preset working condition is a preset working data threshold of the collector.

9. The signal apparatus according to claim 8, wherein the working data comprises a working current or a power of the collector, and the preset working data threshold comprises a preset current threshold or a preset power threshold.

10. The signal apparatus according to claim 7, wherein that the power adjustment module adjusts the first collector voltage value corresponding to the first reference signal in a preset mapping relationship to a second collector voltage value comprises:
the power adjustment module determines an adjustment range of the first collector voltage value based on a preset value; and
the power adjustment module selects, from the adjustment range, a voltage value that meets the preset working condition as the second collector voltage value.

11. The signal apparatus according to claim 10, wherein that the power adjustment module selects, from the adjustment range, a voltage value that meets the preset working condition as the second collector voltage value comprises:
when a plurality of voltage values within the adjustment range meet the preset working condition, the power adjustment module selects a voltage value with minimum power consumption of the collector as the second collector voltage value.

12. The signal apparatus according to claim 7, wherein the first reference signal comprises any one of a reference signal input to the traveling-wave tube, a reference signal output by the traveling-wave tube, and a power back-off signal of the traveling-wave tube.

13. The signal apparatus according to claim 7, wherein the signal apparatus further comprises a detector or a coupler, and the detector or the coupler is disposed at an input end of the traveling-wave tube.

14. The signal apparatus according to claim 13, wherein the detector or the coupler is disposed at an output end of the traveling-wave tube.

15. The signal apparatus according to claim 14, wherein the signal apparatus comprises N traveling-wave tubes, and N is an integer greater than or equal to 1.

16. A signal apparatus, comprising a transceiver unit and a processing unit, wherein
the transceiver unit is configured to obtain a first collector voltage value corresponding to a first reference signal; and
the processing unit is configured to:
determine whether working data of a collector of a traveling-wave tube meets a preset working condition when a voltage is provided for the collector by using the first collector voltage value; and
when the preset working condition is not met, adjust the first collector voltage value corresponding to the first reference signal in a preset mapping relationship to a second collector voltage value, wherein the working data of the collector meets the preset working condition when a voltage is provided for the collector by using the second collector voltage value.

17. A signal apparatus, comprising:
N traveling-wave tubes, wherein the traveling-wave tube comprises a collector, and N is an integer greater than or equal to 1;
a processor, configured to perform the method for adjusting a collector voltage of a traveling-wave tube according to any one of claims 1 to 6; and
a memory, which may be coupled to or decoupled from a controller and is configured to store instructions executed by the controller.

18. A signal apparatus, comprising an input/output interface and a logic circuit, wherein
the input/output interface is configured to obtain a first collector voltage value corresponding to a first reference signal; and
the logic circuit is configured to:
determine whether working data of a collector of a traveling-wave tube meets a preset working condition when a voltage is provided for the collector by using the first collector voltage value; and
when the preset working condition is not met, adjust the first collector voltage value corresponding to the first reference signal in a preset mapping relationship to a second collector voltage value, wherein the working data of the collector meets the preset working condition when a voltage is provided for the collector by using the second collector voltage value.

19. A computer-readable storage medium, wherein the computer-readable storage medium comprises instructions, and when the instructions are executed by a controller of a signal apparatus, the signal apparatus is enabled to implement the method for adjusting a collector voltage of a traveling-wave tube according to any one of claims 1 to 6.

20. A computer program product, comprising a non-volatile computer-readable storage medium, wherein the non-volatile computer-readable storage medium comprises computer program code used to perform the method for adjusting a collector voltage of a traveling-wave tube according to any one of claims 1 to 6.
